Europäisches Patentamt

European Patent Office

Office européen des brevets

(19)

(11) **EP 1 316 142 B1**

(12) **FASCICULE DE BREVET EUROPEEN**

(45) Date de publication et mention
de la délivrance du brevet:
**07.04.2004 Bulletin 2004/15**

(21) Numéro de dépôt: **01984282.2**

(22) Date de dépôt: **09.07.2001**

(51) Int Cl.$^7$: **H03C 7/02**

(86) Numéro de dépôt international:
**PCT/FR2001/002199**

(87) Numéro de publication internationale:
**WO 2002/007303 (24.01.2002 Gazette 2002/04)**

(54) **CIRCUIT DE MODULATION NUMERIQUE DE PHASE ET AMPLITUDE, ET PROCEDE**

DIGITALER PHASEN- UND AMPLITUDENMODULATOR, UND VERFAHREN DAZU

PHASE AND AMPLITUDE DIGITAL MODULATION CIRCUIT AND METHOD

(84) Etats contractants désignés:
**AT BE CH CY DE DK ES FI FR GB GR IE IT LI LU
MC NL PT SE TR**

(30) Priorité: **13.07.2000 FR 0009241**

(43) Date de publication de la demande:
**04.06.2003 Bulletin 2003/23**

(73) Titulaire: **CENTRE NATIONAL D'ETUDES
SPATIALES
F-75039 Paris Cedex 01 (FR)**

(72) Inventeurs:
• **SADOWY, Jérôme**
  **F-32300 Mirande (FR)**
• **BOULANGER, Cyrille**
  **F-31400 Toulouse (FR)**
• **LALAURIE, Jean-Claude**
  **F-31350 Escalquens (FR)**
• **LAPIERRE, Luc**
  **F-31500 Toulouse (FR)**

(74) Mandataire:
**Cabinet BARRE LAFORGUE & associés
95, rue des Amidonniers
31000 Toulouse (FR)**

(56) Documents cités:
FR-A- 2 760 301          US-A- 4 994 773
US-A- 5 063 361          US-A- 5 428 320
US-A- 5 463 355

• A. BOVEDA: "A 0.7-3 GHZ GAAS QPSK/QAM
DIRECT MODULATOR" IEEE JOURNAL OF
SOLID STATE CIRCUITS, vol. 28, no. 12, 1
décembre 1993 (1993-12-01), pages 1340-1349,
XP000435908 NEW YORK ,US cité dans la
demande

**Description**

L'invention concerne un procédé de modulation numérique d'un signal de porteuse périodique de fréquence élevée -notamment pouvant être dans le domaine des hyperfréquences (domaine des fréquences pour lesquelles les phénomènes de propagation ne sont pas négligeables)- avec un signal de modulation numérique en général à plus basse fréquence (c'est-à-dire inférieure à celle du signal de porteuse), mis en oeuvre par un circuit modulateur comprenant au moins une cellule de modulation -notamment par déplacement de phase-destinée à recevoir deux signaux de commande numérique représentatifs d'au moins une partie -notamment une composante- du signal de modulation numérique. Elle s'étend à un circuit électronique modulateur adapté pour la mise en oeuvre d'un tel procédé.

WO-98.38730 décrit un circuit électronique modulateur par déplacement de phase à structure distribuée comprenant une ligne de distribution à n cellules de déphasage, une pluralité de n branches parallèles s'étendant à partir de chaque cellule de déphasage et comprenant chacune un circuit commutateur/modulateur, et des moyens pour sommer en phase les signaux issus des circuits commutateurs/modulateurs. Le nombre d'états de phase pouvant être obtenu peut être supérieur au nombre de branches lorsque celles-ci comportent, à titre de circuit commutateur/modulateur, des cellules de modulation qui, dans la forme de réalisation la plus élémentaire sont des cellules de modulation par déplacement de phase à deux états de phase (dites BPSK ou MDP2) destinées à recevoir deux signaux de commande numériques complémentaires.

La publication BOVEDA et al. : "A O.7-3 GHZ GAAS QPSK/QAM DIRECT MODULATOR" IEEE JOURNAL OF SOLID-STATE CIRCUITS, Vol. 28, n° 12, 1er décembre 1993, pp 1340 - 1349, décrit également d'autres exemples d'applications de cellules dé modulation numérique BPSK pour réaliser des modulations de phase et/ou d'amplitude.

Dans toutes les applications connues de telles cellules de modulation numérique à deux états de phase BPSK telles que décrites par exemple par la publication A. PRIMEROSE et al. "High Bit Rate Four, Phase MMIC Remodulation .Demodulator and Modulator" Proceedings of the GAAS 92 European Gallium Arsenide and related III-V Compounds Applications Symposium, 27-29, April 1992, NOORDWIJK, les signaux de commande numériques appliqués à ces cellules BPSK sont, par principe, des signaux à deux états complémentaires $I, \bar{I}$.

Dès lors, les points du plan de Fresnel (états de phase et/ou d'amplitude) pouvant être adressés dans ces procédés et circuits de modulation numériques connus sont limités à une valeur telle que $2^n$ dans le cas de WO-98.38730.

Or, le besoin se fait sentir de pouvoir augmenter le nombre de points du plan de Fresnel (états de phase et/ou d'amplitude) pour une même structure de circuit, afin d'améliorer les performances de la modulation pour un même prix de revient, un même encombrement, un même poids, et une même consommation énergétique.

L'invention vise donc à satisfaire ce besoin de façon simple et économique. Elle vise en particulier à proposer un procédé et un circuit modulateur permettant d'adresser un grand nombre de points (états de phase et/ou d'amplitude) avec une perte de puissance consommée nulle et une faible consommation d'énergie, de sorte que ce circuit et ce procédé peuvent être adaptés et utilisés avec de nombreux types de codage et de modulation, dans de nombreuses applications.

L'invention vise en outre à proposer un tel procédé et un tel circuit modulateur qui sont avantageusement adaptés à une réalisation en technologie monolithique micro-ondes (MMIC) -notamment sur arséniure de gallium GaAs-avec une excellente précision.

Plus particulièrement, l'invention vise à permettre un choix simple des états de phase et/ou d'amplitude, et ce au moment même de son incorporation dans le système (et non lors de la conception ou de la fabrication du circuit intégré lui-même).

L'invention vise en outre plus particulièrement à proposer un tel procédé et un tel circuit modulateur compatibles avec les contraintes des systèmes spatiaux embarqués (faible encombrement, excellente fiabilité, faible consommation...).

L'invention vise aussi plus particulièrement à proposer un tel procédé et un tel circuit modulateur compatibles avec les codages de modulation à haut débit tels que la MCT, qui deviennent avantageux lorsque l'on dispose d'un grand nombre d'états de phase et/ou d'amplitudes.

L'invention vise aussi plus particulièrement à proposer un tel procédé et un tel circuit modulateur pouvant être adaptés à toute fréquence de signaux porteurs, notamment dans le domaine des hyperfréquences.

L'invention vise aussi plus particulièrement à proposer un tel procédé et un tel circuit modulateur qui, après réalisation peuvent accepter des signaux porteurs en entrée dont la fréquence est fixe, mais peut être choisie dans une large bande (par exemple dans la bande X pour des télémesures d'observation de la terre, dans la bande K des satellites de télécommunication multimédia...).

L'invention vise en outre à proposer une modulation qui ne produise pas de perturbations sensibles de la ligne et du signal d'entrée.

Pour ce faire, l'invention concerne un procédé de modulation d'un signal de porteuse avec un signal de modulation numérique à plus basse fréquence, mis en oeuvre par un circuit modulateur comprenant au moins une cellule de modulation destinée à recevoir deux signaux de commande numériques représentatifs d'au moins une partie du signal de modulation numérique, caractérisé en ce que pour au moins une valeur du signal de modulation numérique, on applique sur au moins une même cellule de modulation, deux signaux de commande numériques de même valeur. Cette cellule de modulation fournit alors, pour cette valeur du signal de modulation numérique (pour laquelle les signaux de commande numériques sont de même valeur) un signal, dit signal élémentaire modulé, qui est différent en amplitude et/ou en phase -notamment qui est nul- de celui qu'elle fournit lorsque les signaux de commande numérique sont complémentaires.

L'invention s'étend aussi à un circuit adapté à la mise en oeuvre du procédé selon l'invention. Elle concerne donc aussi un circuit modulateur apte à réaliser la modulation d'un signal de porteuse avec un signal de modulation numérique à plus basse fréquence, comprenant au moins une cellule de modulation destinée à recevoir deux signaux de commande numériques représentatifs d'au moins une partie du signal de modulation numérique, caractérisé en ce qu'il est adapté pour que, pour au moins une valeur du signal de modulation numérique, au moins une même cellule de modulation reçoit deux signaux de commande numériques de même valeur.

Au moins une cellule de modulation peut être du type à modulation d'amplitude selon un seul état de phase. Néanmoins, avantageusement et selon l'invention, au moins une cellule de modulation est une cellule de modulation par déplacement de phase, le procédé et le circuit selon. l'invention réalisant une modulation numérique au moins par déplacement de phase.

Chaque cellule de modulation peut être une cellule de modulation par déplacement de phase du type à deux états de phase (cellule dite BPSK ou MDP2) -notamment en opposition - présentant en général un seul état d'amplitude, mais pouvant présenter aussi bien deux états d'amplitude. En lui appliquant des signaux de commande numériques de même valeur, on lui donne un, voire deux, état(s) de phase et/ou d'amplitude supplémentaire(s). Dans le cas où la différence de phase entre les deux états est distincte de 180°, et/ou dans le cas où l'amplitude des deux états est différente, ladite cellule de modulation ne fournit pas le même signal élémentaire modulé lorsque les signaux de commande numériques qu'elle reçoit sont égaux à 0, et lorsqu'ils sont égaux à 1. On crée alors deux états supplémentaires pour cette cellule de modulation. Ce signal élémentaire modulé n'est pas nécessairement nul lorsque les signaux de commande numériques sont de même valeur (tous deux égaux à 0 ou à 1).

Néanmoins, de préférence, avantageusement et selon l'invention, au moins une cellule de modulation recevant deux signaux de commande numériques de même valeur pour au moins une valeur du signal de modulation numérique est adaptée pour fournir un signal, dit signal élémentaire modulé, qui est nul pour cette valeur du signal de modulation numérique.

En outre, avantageusement et selon l'invention, au moins une cellule de modulation est adaptée pour fournir un signal élémentaire modulé à deux états de phase en opposition et un seul état d'amplitude lorsqu'elle reçoit des signaux de commande numériques complémentaires, et pour fournir un signal élémentaire modulé qui est nul lorsqu'elle reçoit des signaux de commande numériques de même valeur.

Ainsi, dans un procédé et un circuit selon l'invention, chaque cellule de modulation BPSK fournit un signal modulé pouvant présenter trois, voire quatre, valeurs distinctes -notamment dont l'une est la valeur nulle-, et non uniquement deux valeurs comme dans le cas d'une cellule BPSK traditionnelle. Les différents signaux élémentaires modulés des différentes cellules de modulation sont combinés -notamment sommés en phase- pour former le signal de sortie modulé. Il est ainsi possible d'adresser un plus grand nombre de points du plan de Fresnel.

Avantageusement, un procédé selon l'invention est caractérisé en ce que le circuit modulateur comprend au moins deux cellules de modulation, et en ce que, pour au moins une valeur du signal de modulation numérique, on applique sur au moins une cellule de modulation deux signaux de commande numériques de même valeur (cette cellule de modulation fournissant de préférence un signal élémentaire modulé qui est nul pour cette valeur du signal de modulation numérique), et on applique sur au moins une autre cellule de modulation, deux signaux de commande numériques de valeurs complémentaires (cette autre cellule de modulation fournissant un signal élémentaire modulé qui est non nul pour cette valeur du signal de modulation numérique).

En particulier, dans la variante préférentielle de l'invention, pour une même valeur du signal de modulation numérique, au moins une cellule de modulation fournit un signal élémentaire modulé nul tandis qu'au moins une autre fournit un signal élémentaire modulé non nul.

Avantageusement, un procédé selon l'invention est aussi caractérisé en ce que pour au moins une valeur du signal de modulation numérique, on applique sur au moins une cellule de modulation deux signaux de commande numériques de même valeur et en ce que pour au moins une autre valeur du signal de modulation numérique, on applique sur cette(ces) cellule(s) de modulation deux signaux de commande numériques de valeurs complémentaires. Ainsi, en particulier, une même cellule de modulation ne fournit pas un signal élémentaire modulé nul pour toutes les valeurs du signal de modulation numérique.

Avantageusement et selon l'invention, pour chaque cellule de modulation à deux états de phase en opposition, lorsqu'ils sont de même valeur, les signaux de commande numériques appliqués à une même cellule de modulation sont tous deux égaux à 0. On évite ainsi les dérives dues à l'imperfection technologique du circuit électronique qui n'annulerait pas parfaitement le signal élémentaire modulé pour deux signaux de commande numériques égaux à 1.

Par ailleurs, les cellules de modulation BPSK traditionnelles (telles que décrites par WO-98.38730 (figure 7) ou par la publication A. PRIMEROSE et al. sus-citée) sont bien adaptées en impédance lorsqu'elles reçoivent des signaux de commande à états complémentaires. Néanmoins, tel n'est plus le cas si les signaux de commande prennent simultanément la même valeur, et en particulier tous deux la valeur 0, notamment dans le domaine des hyperfréquences. Les inventeurs ont cependant déterminé qu'il est en fait possible de prévoir des moyens d'adaptation d'impédance tels que l'impédance soit en pratique suffisamment adaptée pour que les signaux de commande soient complémentaires ou égaux, en ce sens que les dérives entraînées par le défaut d'adaptation d'impédance soient inférieures aux, ou du même ordre que les dispersions technologiques.

Ainsi, avantageusement et selon l'invention, on fournit un signal d'entrée issu du signal de porteuse à chaque cellule de modulation par l'intermédiaire de moyens d'adaptation d'impédance adaptés pour que la cellule de modulation soit au moins sensiblement adaptée en impédance aussi bien lorsque les signaux de commande numériques qu'elle reçoit sont complémentaires que lorsqu'ils sont égaux. Avantageusement et selon l'invention, les moyens d'adaptation d'impédance comprennent pour chaque cellule de modulation un transistor qui reçoit le signal d'entrée et est relié à la cellule de modulation, et une résistance parallèle entre le transistor et la masse.

En outre, avantageusement et selon l'invention, on utilise un circuit modulateur à structure distribuée comprenant plusieurs branches dérivées comprenant chacune au moins une cellule de modulation destinée à recevoir deux signaux de commande numériques, chaque branche dérivée délivrant un signal, dit signal de sortie de branche modulé, et on somme en phase les signaux de sortie de branche modulés issùs des différentes branches dérivées pour former un signal de sortie modulé. En particulier, on utilise un circuit modulateur conforme à la structure distribuée décrite dans WO/98.38730. Le nombre d'états de phase de chaque cellule de modulation BPSK est, dans le procédé de l'invention, non pas égal à 2 mais à 3, ce qui permet d'adresser avec le signal de sortie modulé $3^n$ points du plan de Fresnel, n étant le nombre de branches du circuit (et non $2^n$ comme dans WO/98.38730).

L'invention s'étend à un circuit modulateur caractérisé en ce qu'il est adapté pour la mise en oeuvre des caractéristiques sus-mentionnées du procédé selon l'invention. En particulier, un circuit selon l'invention comprend avantageusement à l'amont de chaque cellule de modulation, des moyens d'adaptation d'impédance fournissant un signal d'entrée issu du signal de porteuse à la cellule de modulation et adaptés pour que la cellule de modulation soit au moins sensiblement adaptée en impédance aussi bien lorsque les signaux de commande numériques qu'elle reçoit sont complémentaires que lorsqu'ils sont égaux.

L'invention concerne aussi un procédé et un circuit modulateur caractérisés en combinaison par tout ou partie des caractéristiques mentionnées ci-dessus ou ci-après.

D'autres buts, caractéristiques et avantages de l'invention apparaissent à la lecture de la description suivante qui se réfère aux figures annexées, dans lesquelles :

- la figure 1 est un schéma de principe d'un circuit modulateur selon l'invention,
- la figure 2 est un schéma d'un exemple de réalisation d'un circuit modulateur selon un mode de réalisation de l'invention à structure distribuée à quatre branches,
- la figure 3 est un diagramme de Fresnel illustrant un exemple de construction vectorielle dans le plan complexe du signal de sortie modulé du circuit de la figure 2,
- la figure 4 est un diagramme de Fresnel illustrant les différents points du plan complexe de Fresnel pouvant être adressés par le circuit de la figure 2, et un exemple d'application de l'invention pour la réalisation d'une modulation 16-PSK,
- la figure 5 est identique à la figure 4 mais représente un autre exemple d'application de l'invention pour la réalisation d'une modulation 16-QAM.

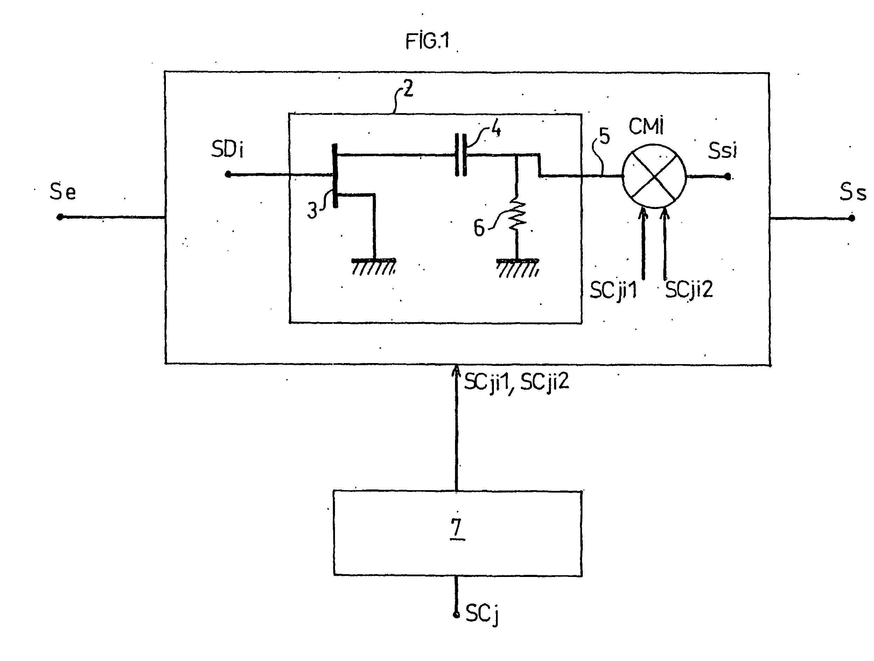

La figure 1 représente un circuit modulateur 1 selon l'invention recevant un signal d'entrée, dit signal de porteuse Se=A.sin($\bar{\omega}$e.t+$\phi$e), et un signal de modulation SCj qui est un signal numérique ou représente un signal numérique, et délivrant un signal de sortie modulé Ss=A'.sin($\bar{\omega}$s.t+$\phi$s). Dans le cas d'une modulation par déplacement de phase (dite PSK "phase shift keying"), le signal de sortie modulé Ss est modulé en phase en fonction du signal de modulation numérique SCj, par exemple de type NRZ. En général, $\bar{\omega}$s=$\bar{\omega}$e.

Le circuit modulateur 1 selon l'invention comprend au moins une cellule de modulation CMi par déplacement de phase du type destinée à recevoir deux signaux de commande numériques SCji1, SCji2 représentatifs d'au moins une partie du signal de modulation SCj.

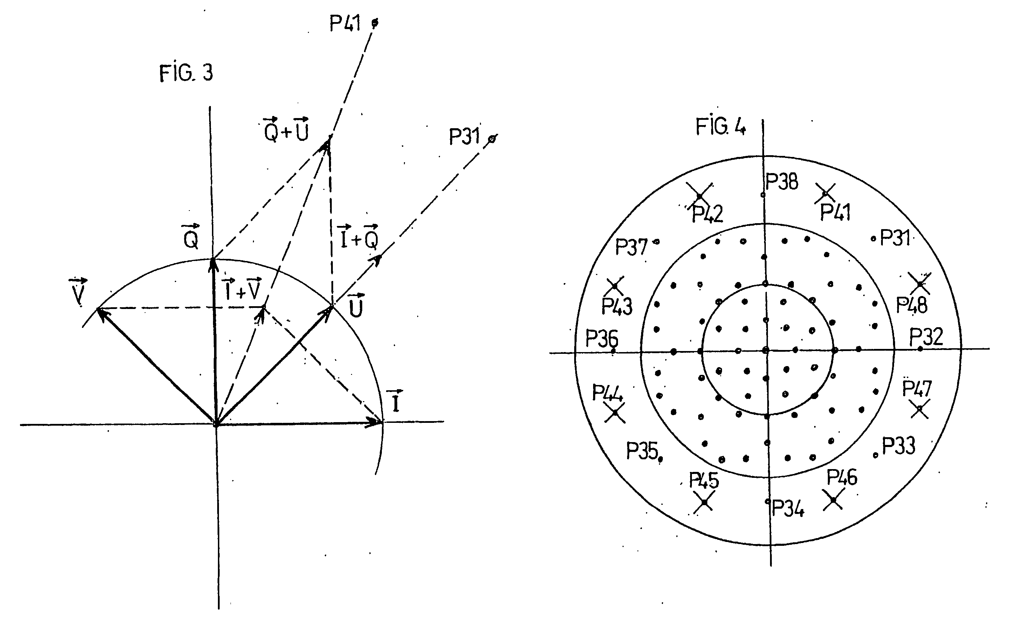

Une telle cellule de modulation CMi peut être formée d'une cellule de modulation BPSK traditionnelle à deux états de phase en opposition et un seul état d'amplitude (lorsque les signaux de commande numériques sont complémentaires). Une telle cellule de modulation CMi est par exemple décrite dans la publication A. PRIMEROSE et al. sus-citée (figure 3b) et comprend deux commutateurs formés de transistors à effet de champ et deux filtres d'entrée. à savoir un filtre passe-bas induisant un déphasage de -90° et un filtre passe-haut induisant un déphasage de +90°. En variante ou en combinaison, on peut aussi utiliser une cellule de modulation BPSK telle que décrite dans WO/98.38730 (figure 7).

On modifie néanmoins ces cellules de modulation BPSK de façon à pouvoir leur appliquer des signaux de commande numériques SCji1, SCji2 de valeurs simultanément identiques. Dans le cas d'une, cellule de la publication A. PRIMEROSE et al, ces signaux de commande numériques sont formés par les tensions Vg, et $\overline{V}$ g respectivement. Dans le cas de la cellule de WO/98.38730 (figure 7), les signaux de commande numériques SCji1 et SCji2 sont appliqués selon l'invention sur les grilles, des transistors commutateurs CO0 et CO1, respectivement, à la place des signaux, complémentaires formés à partir du signal de modulation dans ce circuit.

Par ailleurs, le circuit modulateur 1 selon l'invention comprend des moyens 2 d'adaptation d'impédance d'entrée via lesquels un signal d'entrée SDi issu du signal de porteuse Se est fourni à la cellule CMi en vue de sa modulation. Ce signal d'entrée SDi est issu directement ou indirectement (via des circuits d'entrée pouvant ou non participer à la modulation et notamment pouvant comprendre ou non une ou plusieurs autre(s) cellule(s) de modulation). Ces moyens 2 d'adaptation d'impédance d'entrée permettent d'assurer au moins sensiblement l'adaptation d'impédance de la cellule de modulation CMi quelles que soient les valeurs des signaux de commande SCji1, SCji2 qui lui sont appliqués, c'est-à-dire qu'ils soient complémentaires ou égaux.

Ces moyens 2 d'adaptation d'impédance comportent un transistor 3 -notamment à effet de champ, en particulier PHEMT (sur GaAs)-recevant le signal d'entrée SDi sur la grille, ayant sa source reliée à la masse et son drain alimentant une capacité 4 qui est reliée à l'entrée 5 de la cellule de modulation CMi, et une résistance parallèle 6 reliée entre l'entrée 5 de la cellule de modulation CMi et la masse. En variante, le transistor 3 peut être un transistor bipolaire.

..Le transistor 3 et la capacité 4 isolent la cellule de modulation CMi de l'entrée du circuit 1, de sorte que le signal de porteuse Se n'est pas perturbé par la modulation.

La résistance parallèle 6 est choisie pour présenter une impédance correspondant à celle de la cellule de modulation CMi lorsque les signaux de commande SCji1, SCji2 sont complémentaires, notamment de l'ordre de 50 Ω. De la sorte, l'impédance d'entrée de la cellule de modulation CMi reste de l'ordre de cette impédance, notamment de l'ordre de 50Ω (entre 10Ω et 100Ω).

Egalement, l'impédance en sortie doit être adaptée pour les différentes valeurs des signaux de commande numériques. Cela est obtenu en pratique par le fait que le signal élémentaire modulé Ssi fourni par la cellule de modulation CMi est en général combiné en phase avec les autres signaux issus d'autres cellules de modulation CMi par ou plusieurs coupleurs de Wilkinson (coupleurs de puissance en phase) qui ont pour effet de masquer des déséquilibres d'impédance entre cellules de modulation CMi en parallèle.

En variante, il est aussi possible de dupliquer symétriquement en sortie les moyens 2 d'adaptation d'impédance d'entrée en reliant la sortie Ssi à une résistance parallèle (à la masse) et à la grille d'un transistor à effet de champ dont la source est à la masse. Il est aussi possible d'utiliser un transistor bipolaire.

Le circuit modulateur 1 selon l'invention comprend des moyens 7 de transcodage aptes à générer les signaux de commande numériques SCji1, SCji2 de chaque cellule de modulation CMi à partir du signal de modulation numérique SCj. Ces moyens 7 de transcodage sont formés d'une simple table logique programmée dans un circuit logique adapté à cet effet. Pour certaines valeurs du signal de modulation SCj, les signaux de commande SCji1, SCji2 d'au moins une cellule de modulation CMi sont identiques (tous deux égaux à 0 ou à 1). De préférence, tous les signaux de commande SCji1, SCji2 de toutes les cellules de modulation CMi ne sont pas tous identiques simultanément, la modulation n'utilisant pas l'origine du plan de Fresnel en tant que point actif.

En pratique, l'ensemble du circuit modulateur 1 selon l'invention peut être constitué, à l'exception des moyens 7 de transcodage et des moyens 2 d'adaptation d'impédance, d'un circuit modulateur traditionnel, notamment un circuit à structure distribuée tel que décrit par WO/98.38730, comprenant une ligne de distribution 8, formant des cellules de déphasage semblables bout à bout en échelle définissant des noeuds de dérivation de branches dérivées Bi. Chaque branche dérivée Bi comprend au moins une cellule de modulation CMi. La ligne de distribution 8 comprend par exemple des inductances séries semblables Li entre une capacité d'entrée 9 et un dispositif de terminaison 10, et des transistors Ti à effet de champ -notamment MESFET (sur GaAs)- reliés par leur grille aux noeuds Ni, par leur source à la masse et dont le drain forme une branche dérivée Bi. Le transistor Ti fait office de transistor 3 des moyens 2 d'adaptation d'impédance d'une cellule de modulation CMi appartenant à la branche dérivée Bi.

De préférence, le circuit modulateur 1 comprend plus de deux branches dérivées Bi. En outre, chaque branche dérivée Bi peut être une ligne simple comprenant une telle cellule de modulation CMi (chaque branche Bi fournissant alors un signal de sortie de branche Ssi formé du signal élémentaire modulé Ssi fourni par la cellule de modulation CMi), ou au contraire être elle-même un circuit à structure distribuée, le circuit modulateur 1 étant formé d'une arborescence à plusieurs structures distribuées imbriquées.

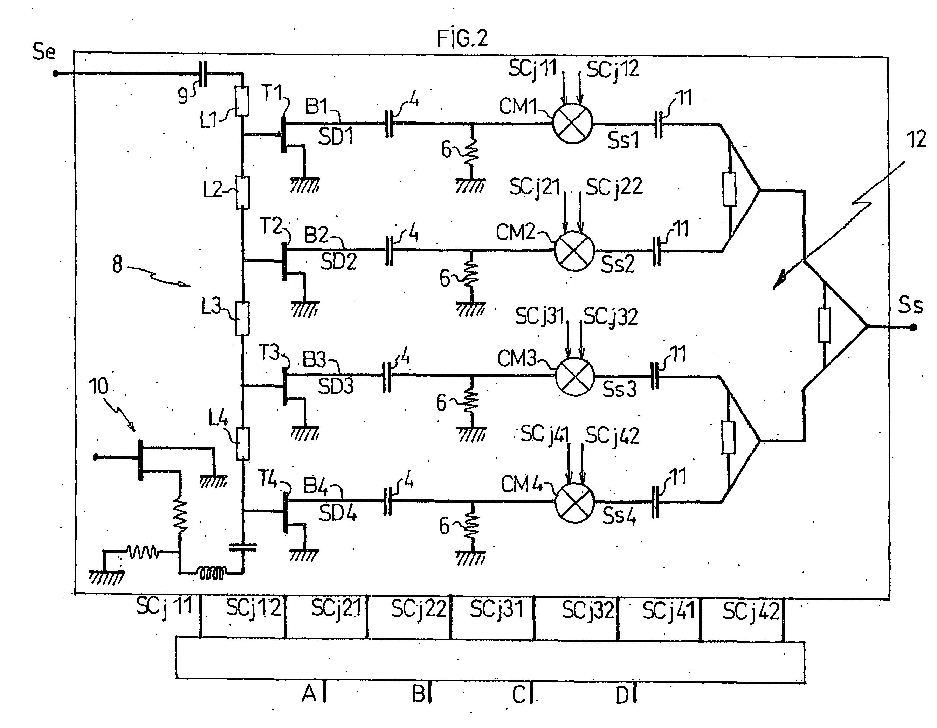

La figure 2 représente un exemple de réalisation à quatre branches dérivées B1, B2, B3, B4, comprenant chacune une cellule de modulation CM1, CM2, CM3, CM4, la ligne de distribution 8 comprenant quatre inductances L1, L2, L3, L4 et quatre transistors T1, T2, T3, T4 fournissant les signaux d'entrée SD1, SD2, SD3, SD4 à chaque branche. Chaque cellule de modulation CM1, CM2, CM3, CM4 fournit un signal élémentaire modulé Ss1, Ss2, Ss3, Ss4 délivré par l'intermédiaire d'une capacité d'isolement 11 en sortie à un double étage 12 de coupleurs de Wilkinson sommant en phase ces signaux élémentaires modulés (qui sont aussi les signaux de sortie de branche) pour former le signal de sortie modulé Ss.

Le signal de modulation SCj étant un signal numérique sur quatre bits ABCD, les moyens 7 de transcodage élaborent les signaux de commande SCji1, SCji2 des cellules de modulation CMi selon la constellation que l'on souhaite utiliser pour le protocole de modulation. Si les signaux d'entrée SDi sont déphasés entre eux de 45° (par la ligne de distribution 8) et formés respectivement des vecteurs $\bar{I}$ $\bar{U}$ $\bar{Q}$ $\bar{V}$ tels que représentés figure 3, les moyens 7 de transcodage peuvent être agencés selon la table logique ci-après pour adresser les 16 points P 31 à P 38 ; P 41 à P 48 de la constellation de plus grande amplitude représentée figure 4. On obtient alors un circuit à 16 états de phases (16-PSK) de façon extrêmement simple et fiable.

**EP 1 316 142 B1**

| Signal de modulation | | | | Signaux de commande | | | | | | | | Signaux de sortie de branche | | | | Points |
|---|---|---|---|---|---|---|---|---|---|---|---|---|---|---|---|---|
| A | B | C | D | SCj11 | SCj12 | Scj21 | SCj22 | SCj31 | SCj32 | SCj41 | SCj42 | Ss1 | Ss2 | Ss3 | Ss4 | |
| 0 | 0 | 0 | 0 | 0 | 1 | 0 | 1 | 0 | 1 | 0 | 1 | I | U | Q | V | P41 |
| 0 | 0 | 1 | 0 | 1 | 0 | 0 | 1 | 0 | 1 | 0 | 1 | -I | U | Q | V | P42 |
| 0 | 1 | 0 | 0 | 1 | 0 | 1 | 0 | 0 | 1 | 0 | 1 | -I | -U | Q | V | P43 |
| 0 | 1 | 1 | 0 | 1 | 0 | 1 | 0 | 1 | 0 | 0 | 1 | -I | -U | -Q | V | P44 |
| 1 | 0 | 0 | 0 | 1 | 0 | 1 | 0 | 1 | 0 | 1 | 0 | -I | -U | -Q | -V | P45 |
| 1 | 0 | 1 | 0 | 0 | 1 | 1 | 0 | 1 | 0 | 1 | 0 | I | -U | -Q | -V | P46 |
| 1 | 1 | 0 | 0 | 0 | 1 | 0 | 1 | 1 | 0 | 1 | 0 | I | U | -Q | -V | P47 |
| 1 | 1 | 1 | 0 | 0 | 1 | 0 | 1 | 0 | 1 | 1 | 0 | I | U | Q | -V | P48 |
| 0 | 0 | 0 | 1 | 0 | 1 | 0 | 1 | 0 | 1 | 0 | 0 | I | U | Q | 0 | P31 |
| 0 | 0 | 1 | 1 | 0 | 1 | 0 | 1 | 0 | 0 | 1 | 0 | I | U | 0 | -V | P32 |
| 0 | 1 | 0 | 1 | 0 | 1 | 0 | 0 | 1 | 0 | 1 | 0 | I | 0 | -Q | -V | P33 |
| 0 | 1 | 1 | 1 | 0 | 0 | 1 | 0 | 1 | 0 | 1 | 0 | 0 | -U | -Q | -V | P34 |
| 1 | 0 | 0 | 1 | 1 | 0 | 1 | 0 | 1 | 0 | 0 | 0 | -I | -U | -Q | 0 | P35 |
| 1 | 0 | 1 | 1 | 1 | 0 | 1 | 0 | 0 | 0 | 0 | 1 | -I | -U | 0 | V | P36 |
| 1 | 1 | 0 | 1 | 1 | 0 | 0 | 0 | 0 | 1 | 0 | 1 | -I | 0 | Q | V | P37 |
| 1 | 1 | 1 | 1 | 0 | 0 | 0 | 1 | 0 | 1 | 0 | 1 | 0 | U | Q | V | P38 |

Les points P41 à P48 sont ceux obtenus traditionnellement lorsque les signaux de commande SCji1, SCji2 sont complémentaires. Les points P31 à P38 sont obtenus avec des signaux de commande identiques sur l'une des branches. La figure 3 illustre l'exemple de la construction vectorielle des points P31 et P41.

Comme on le voit figure 4, on peut au moins doubler le nombre de points de la constellation de façon extrêmement simple et économique, par simple programmation logique de la table de codage, sans modification structurelle du circuit. Il est à noter que l'amplitude théorique des points P31 à P38 est inférieure de 0,7dB à celle des points P41 à P48. Ainsi, au lieu des deux constellations de 8 points (deux fois huit états de phase, avec des amplitudes différentes) obtenus dans le circuit de WO/98.38730, on obtient avec l'invention 80 points (l'origine étant en général exclue), et en particulier 8 points supplémentaires dont l'amplitude est du même ordre (inférieure de 0,7 dB uniquement) que celle de la grande constellation du circuit de WO/98.38730, mais déphasés de 22,5° par rapport à ces points, de sorte que l'on dispose d'une constellation de 16 états de phase avec une précision en amplitude acceptable pour des systèmes de codage performants tels que la MCTM (modulation codée treillis multidimensionnelle).

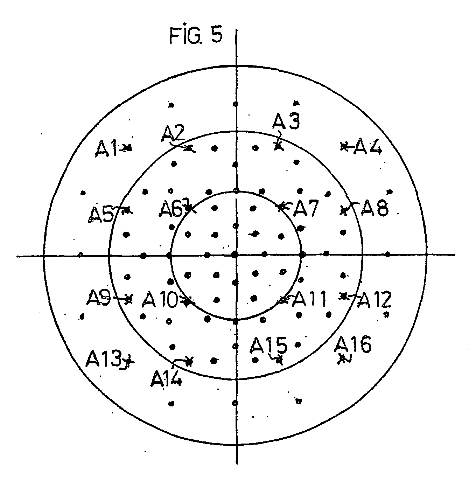

Sur la figure 5, on a représenté un exemple de constellation formée de 16 points A1,A2, A3, A4, A5, A6, A7, A8, A9, A10, A11, A12, A13, A14, A15, A16, permettant de réaliser une modulation16-QAM avec une précision acceptable.

Dans les différents cas, il est possible de réduire les imprécisions théoriques en utilisant à l'aval un amplificateur de puissance dans sa zone de compression.

Les figures 4 et 5 représentent tous les points ($3^4$-1=80 points en plus de l'origine) pouvant être obtenus selon les valeurs des signaux de commande SCji1, SCji2 des quatre branches dérivées, en y intégrant les couples de valeurs identiques (0, 0) et/ou (1, 1). De préférence, comme dans la table mentionnée ci-dessus, on n'utilise que le couple (0, 0) et non le couple (1, 1) susceptible de générer des dérives technologiques plus importantes.

Tous les points de la constellation des figures 4 et 5 peuvent être adressés pour une modulation par déplacement de phase et/ou en amplitude.

L'invention peut faire l'objet de nombreuses variantes de réalisation par rapport aux exemples non limitatifs décrits ci-dessus et représentés.

Elle est avantageusement applicable à la réalisation d'un circuit modulateur dans le domaine des hyperfréquences (classiquement de 1GHz à 300 GHz) où les phénomènes de propagation sont importants, et en technologie monolithique micro-ondes MMIC -notamment sur arséniure de gallium-. Elle est aussi applicable pour la réalisation de circuits modulateurs dans toutes les gammes de fréquence.

Pour être compatible avec les fréquences de travail des circuits numériques, le signal de modulation SCj est en général à une fréquence inférieure à celle ($\overline{\omega}$e/2π) du signal de porteuse. Par exemple, si $\overline{\omega}$e/2π est dans le domaine des hyperfréquences, la fréquence du signal de modulation SCj peut être de l'ordre de 100 MHz.

**Revendications**

**1.** Procédé de modulation d'un signal de porteuse périodique (Se) avec un signal (SCj) de modulation numérique, mis en oeuvre par un circuit modulateur (1) comprenant au moins une cellule de modulation (CMi) destinée à recevoir deux signaux de commande numériques (SCji1, SCji2) pouvant être égaux à 0 ou à 1, représentatifs d'au moins une partie du signal (SCj) de modulation numérique, dans lequel pour au moins une valeur du signal (SCj) de modulation numérique, on applique sur au moins une même cellule de modulation (CMi), deux signaux de commande numériques (SCji1, SCji2) de même valeur, et pour au moins une autre valeur du signal (SCj) de modulation numérique, on applique sur cette(ces) cellule(s) de modulation (CMi) deux signaux (SCji1, SCji2) de commande numériques de valeurs complémentaires.

**2.** Procédé selon la revendication 1, **caractérisé en ce qu'**au moins une cellule de modulation (CMi) recevant deux signaux de commande numériques (SCji1, SCji2) de même valeur pour au moins une valeur du signal de modulation numérique (SCj) est adaptée pour fournir un signal, dit signal élémentaire modulé (Ssi), qui est nul pour cette valeur du signal de modulation numérique (SCj).

**3.** Procédé selon l'une des revendications 1 ou 2, **caractérisé en ce qu'**au moins une cellule de modulation (CMi) est une cellule de modulation par déplacement de phase.

**4.** Procédé selon l'une des revendications 1 à 3, **caractérisé en ce qu'**au moins une cellule de modulation (CMi) est adaptée pour fournir un signal élémentaire modulé (Ssi) à deux états de phase en opposition et un seul état d'amplitude lorsqu'elle reçoit des signaux de commande numériques (SCji1, SCji2) complémentaires, et pour fournir un signal élémentaire modulé (Ssi) qui est nul lorsqu'elle reçoit des signaux de commande numériques (SCji1, SCji2) de même valeur.

**5.** Procédé selon la revendication 4, **caractérisé en ce que** lorsque les deux signaux de commande numériques (SCji1, SCji2) sont de même valeur, ils sont tous deux égaux à 0.

**6.** Procédé selon l'une des revendications 1 à 5, **caractérisé en ce que** le circuit modulateur (1) comprend au moins deux cellules de modulation (CMi), et **en ce que**, pour au moins une valeur du signal (SCj) de modulation numérique, on applique sur au moins une cellule de modulation (CMi) deux signaux de commande numériques (SCji1, SCji2) de même valeur, et on applique sur au moins une autre cellule de modulation (CMi), deux signaux de commande numériques (SCji1, SCji2) de valeurs complémentaires.

**7.** Procédé selon l'une des revendications 1 à 6, **caractérisé en ce qu'**on fournit un signal d'entrée (SDi) issu du signal de porteuse (Se) à chaque cellule de modulation (CMi) par l'intermédiaire de moyens (2) d'adaptation d'impédance adaptés pour que la cellule de modulation (CMi) soit au moins sensiblement adaptée en impédance aussi bien lorsque les signaux (SCji1, SCji2) de commande numériques qu'elle reçoit sont complémentaires que lorsqu'ils sont égaux.

**8.** Procédé selon la revendication 7, **caractérisé en ce que** les moyens (2) d'adaptation d'impédance comprennent pour chaque cellule de modulation (CMi) un transistor (3) qui reçoit le signal d'entrée (SDi) et est relié à la cellule de modulation (CMi), et une résistance parallèle (6) entre le transistor (3) et la masse.

**9.** Procédé selon l'une des revendications 1 à 8, **caractérisé en ce qu'**on utilise un circuit modulateur (1) à structure distribuée comprenant plusieurs branches dérivées (Bi) comprenant chacune au moins une cellule de modulation (CMi) destinée à recevoir deux signaux (SCji1, SCji2) de commande numériques, chaque branche dérivée (Bi) délivrant un signal, dit signal de sortie de branche modulé (Ssi), et **en ce qu'**on somme en phase les signaux de sortie de branche modulés (Ssi) issus des différentes branches dérivées (Bi) pour former un signal de sortie modulé (Ss).

**10.** Circuit modulateur apte à réaliser la modulation d'un signal de porteuse périodique (Se) avec un signal (SCj) de modulation numérique, comprenant au moins une cellule de modulation (CMi) destinée à recevoir deux signaux (SCji1, SCji2) de commande numériques pouvant être égaux à 0 ou à 1, représentatifs d'au moins une partie du signal (SCj) de modulation numérique, ce circuit étant adapté pour que, pour au moins une valeur du signal (SCj) de modulation numérique, au moins une même cellule de modulation (CMi) reçoit deux signaux (SCji1, SCji2) de commande numériques de même valeur, et pour que, pour au moins une autre valeur du signal (SCj) de modulation numérique, cette(ces) cellule(s) de modulation (CMi) reçoit deux signaux (SCji1, SCji2) de commande numériques de valeurs complémentaires.

**11.** Circuit selon la revendication 10, **caractérisé en ce qu'**au moins une cellule de modulation (CMi) recevant deux signaux de commande numériques (SCji1, SCji2) de même valeur pour au moins une valeur du signal de modulation numérique (SCj) est adaptée pour fournir un signal, dit signal élémentaire modulé (Ssi), qui est nul pour cette valeur du signal de modulation numérique (SCj).

**12.** Circuit selon l'une des revendications 10 ou 11, **caractérisé en ce qu'**au moins une cellule de modulation (CMi) est une cellule de modulation par déplacement de phase.

**13.** Circuit selon l'une des revendications 10 à 12, **caractérisé en ce qu'**au moins une cellule de modulation (CMi) est adaptée pour fournir un signal élémentaire modulé (Ssi) à deux états de phase en opposition et un seul état d'amplitude lorsqu'elle reçoit des signaux de commande numériques (SCji1, SCji2) complémentaires, et pour fournir un signal élémentaire modulé (Ssi) qui est nul lorsqu'elle reçoit des signaux de commande numériques (SCji1, SCji2) de même valeur.

**14.** Circuit selon la revendication 13, **caractérisé en ce que** lorsque les deux signaux de commande numériques (SCji1, SCji2) sont de même valeur, ils sont tous deux égaux à 0.

**15.** Circuit selon l'une des revendications 10 à 14, **caractérisé en ce qu'**il comprend au moins deux cellules de modulation (CMi), et **en ce qu'**il est adapté pour que pour au moins une valeur du signal (SCj) de modulation numérique, au moins une cellule de modulation (CMi) reçoit deux signaux (SCji1, SCji2) de commande numériques de même valeur, et au moins une autre cellule de modulation (CMi) reçoit deux signaux (SCji1, SCji2) de commande numériques de valeurs complémentaires.

**16.** Circuit selon l'une des revendications 10 à 15, **caractérisé en ce qu'**il comprend, à l'amont de chaque cellule de modulation (CMi), des moyens (2) d'adaptation d'impédance fournissant un signal d'entrée (SDi) issu du signal de porteuse (Se) à la cellule de modulation (CMi) et adaptés pour que la cellule de modulation (CMi) soit au moins sensiblement adaptée en impédance aussi bien lorsque les signaux (SCji1, SCji2) de commande numériques qu'elle reçoit sont complémentaires que lorsqu'ils sont égaux.

**17.** Circuit selon la revendication 16, **caractérisé en ce que** les moyens (2) d'adaptation d'impédance comprennent pour chaque cellule de modulation (CMi) un transistor (3) qui reçoit le signal d'entrée (SDi) et est relié à la cellule de modulation (CMi), et une résistance parallèle (6) entre le transistor et la masse.

**18.** Circuit selon l'une des revendications 10 à 17, **caractérisé en ce qu'**il présente une structure distribuée comprenant plusieurs branches dérivées (Bi) comprenant chacune au moins une cellule de modulation (CMi) destinée à recevoir deux signaux (SCji1, SCji2) de commande numériques, chaque branche dérivée (Bi) délivrant un signal, dit signal de sortie de branche modulé (Ssi), et des moyens (12) pour sommer en phase les signaux de sortie de branche modulés (Ssi) issus des différentes branches dérivées (Bi) pour former un signal de sortie modulé (Ss).


**Patentansprüche**

**1.** Verfahren zum Modulieren eines periodischen Trägersignals (Se) mit einem digitalen Modulationssignal (SCj), ausgeführt mit einer Modulatorschaltung (1), die wenigstens eine Modulationszelle (CMi) zum Empfangen von zwei digitalen Steuersignalen (SCji1, SCji2) umfasst, die gleich 0 oder 1 sein können und die für wenigstens einen Teil des digitalen Modulationssignals (SCj) repräsentativ sind, bei dem für wenigstens einen Wert des digitalen Modulationssignals (SCj) an wenigstens eine selbe Modulationszelle (CMi) zwei digitale Steuersignale (SCji1, SCji2) mit demselben Wert angelegt werden und für wenigstens einen anderen Wert des digitalen Modulationssignals (SCj) an diese Modulationszelle(n) (CMi) zwei digitale Steuersignale (SCji1, SCji2) mit komplementären Werten angelegt werden.

**2.** Verfahren nach Anspruch 1, **dadurch gekennzeichnet, dass** wenigstens eine Modulationszelle (CMi), die zwei digitale Steuersignale (SCji1, SCji2) desselben Wertes für wenigstens einen Wert des digitalen Modulationssignals (SCj) empfängt, die Aufgabe hat, ein Signal zu erzeugen, moduliertes Grundsignal (Ssi) genannt, das für diesen Wert des digitalen Modulationssignals (SCj) null ist.

**3.** Verfahren nach Anspruch 1 oder 2, **dadurch gekennzeichnet, dass** wenigstens eine Modulationszelle (CMi) eine durch Phasenverschiebung modulierte Zelle ist.

**4.** Verfahren nach einem der Ansprüche 1 bis 3, **dadurch gekennzeichnet, dass** wenigstens eine Modulationszelle (CMi) die Aufgabe hat, ein moduliertes Grundsignal (Ssi) mit zwei einander entgegengesetzten Phasenzuständen und einem einzigen Amplitudenzustand zu erzeugen, wenn sie komplementäre digitale Steuersignale (SCji1, SCji2) erhält, und ein moduliertes Grundsignal (Ssi) zu erzeugen, das null ist, wenn es digitale Steuersignale (SCji1, SCji2) desselben Wertes erhält.

**5.** Verfahren nach Anspruch 4, **dadurch gekennzeichnet, dass**, wenn die beiden digitalen Steuersignale (SCji1, SCji2) denselben Wert haben, beide gleich 0 sind.

**6.** Verfahren nach einem der Ansprüche 1 bis 5, **dadurch gekennzeichnet, dass** die Modulatorschaltung (1) wenigstens zwei Modulationszellen (CMi) umfasst, und dadurch, dass für wenigstens einen Wert des digitalen Modulationssignals (SCj) an wenigstens eine Modulationszelle (CMi) zwei digitale Steuersignale (SCji1, SCji2) desselben Wertes angelegt werden und an wenigstens eine andere Modulationszelle (CMi) zwei digitale Steuersignale (SCji1, SCji2) mit komplementären Werten angelegt werden.

**7.** Verfahren nach einem der Ansprüche 1 bis 6, **dadurch gekennzeichnet, dass** ein auf dem Trägersignal (Se) basierendes Eingangssignal (SDi) zu jeder Modulationszelle (CMi) mit Hilfe von Impedanzanpassungsmitteln (2) gesendet wird, die so gestaltet sind, dass die Impedanz der Modulationszelle (CMi) wenigstens im Wesentlichen gleich gut angepasst ist, wenn die digitalen Steuersignale (SCji1, SCji2), die sie empfängt, komplementär sind wie wenn sie gleich sind.

**8.** Verfahren nach Anspruch 7, **dadurch gekennzeichnet, dass** die Impedanzanpassungsmittel (2) für jede Modulationszelle (CMi) einen Transistor (3), der das Eingangssignal (SDi) empfängt und mit der Modulationszelle (CMi) verbunden ist, und einen parallelen Widerstand (6) zwischen dem Transistor (3) und Masse umfasst.

9. Verfahren nach einem der Ansprüche 1 bis 8, **dadurch gekennzeichnet, dass** eine Modulatorschaltung (1) mit verteilter Struktur verwendet wird, die mehrere abgeleitete Zweige (Bi) umfasst, die jeweils wenigstens eine Modulationszelle (CMi) zum Empfangen von zwei digitalen Steuersignalen (SCji1, SCji2) umfassen, wobei jeder abgeleitete Zweig (Bi) ein Signal liefert, moduliertes Zweigausgangssignal (Ssi) genannt, und dadurch, dass die modulierten Zweigausgangssignale (Ssi) von den verschiedenen abgeleiteten Zweigen (Bi) phasensummiert werden, um ein moduliertes Ausgangssignal (Ss) zu bilden.

10. Modulatorschaltung zum Durchführen der Modulation eines periodischen Trägersignals (Se) mit einem digitalen Modulationssignal (SCj), die wenigstens eine Modulationszelle (CMi) zum Empfangen von zwei digitalen Steuersignalen (SCji1, SCji2) umfasst, die gleich 0 oder 1 sein können und die für wenigstens einen Teil des digitalen Modulationssignals (SCj) repräsentativ sind, wobei diese Schaltung so gestaltet ist, dass für wenigstens einen Wert des digitalen Modulationssignals (SCj) wenigstens eine selbe Modulationszelle (CMi) zwei digitale Steuersignale (SCji1, SCji2) desselben Wertes erhält, und dass für wenigstens einen anderen Wert des digitalen Modulationssignals (SCj) diese Modulationszelle(n) (CMi) zwei digitale Steuersignale (SCji1, SCji2) mit komplementären Werten erhält/erhalten.

11. Schaltung nach Anspruch 10, **dadurch gekennzeichnet, dass** wenigstens eine Modulationszelle (CMi), die zwei digitale Steuersignale (SCji1, SCji2) desselben Wertes für wenigstens einen Wert des digitalen Modulationssignals (SCj) empfängt, die Aufgabe hat, ein Signal zu erzeugen, moduliertes Grundsignal (Ssi) genannt, das für diesen Wert des digitalen Modulationssignals (SCj) null ist.

12. Schaltung nach Anspruch 10 oder 11, **dadurch gekennzeichnet, dass** wenigstens eine Modulationszelle (CMi) eine durch Phasenverschiebung modulierte Zelle ist.

13. Schaltung nach einem der Ansprüche 10 bis 12, **dadurch gekennzeichnet, dass** wenigstens eine Modulationszelle (CMi) die Aufgabe hat, ein moduliertes Grundsignal (Ssi) mit zwei einander entgegengesetzten Phasenzuständen und einem einzigen Amplitudenzustand zu erzeugen, wenn sie komplementäre digitale Steuersignale (SCji1, SCji2) erhält, und ein moduliertes Grundsignal (Ssi) zu erzeugen, das null ist, wenn es digitale Steuersignale (SCji1, SCji2) desselben Wertes erhält.

14. Schaltung nach Anspruch 13, **dadurch gekennzeichnet, dass**, wenn die beiden digitalen Steuersignale (SCji1, SCji2) denselben Wert haben, beide gleich 0 sind.

15. Schaltung nach einem der Ansprüche 10 bis 14, **dadurch gekennzeichnet, dass** sie wenigstens zwei Modulationszellen (CMi) umfasst, und dadurch, dass sie so gestaltet ist, dass für wenigstens einen Wert des digitalen Modulationssignals (SCj) wenigstens eine Modulationszelle (CMi) zwei digitale Steuersignale (SCji1, SCji2) desselben Wertes erhält und wenigstens eine andere Modulationszelle (CMi) zwei digitale Steuersignale (SCji1, SCji2) mit komplementären Werten erhält/erhalten.

16. Schaltung nach einem der Ansprüche 10 bis 15, **dadurch gekennzeichnet, dass** sie jeder Modulationszelle (CMi) vorgeschaltet Impedanzanpassungsmittel (2) umfasst, die ein auf dem Trägersignal (Se) basierendes Eingangssignal (SDi) zu jeder Modulationszelle (CMi) senden und so gestaltet sind, dass die Impedanz der Modulationszelle (CMi) wenigstens im Wesentlichen genauso gut angepasst ist, wenn die digitalen Steuersignale (SCji1, SCji2), die sie empfängt, komplementär sind wie wenn sie gleich sind.

17. Schaltung nach Anspruch 16, **dadurch gekennzeichnet, dass** die Impedanzanpassungsmittel (2) für jede Modulationszelle (CMi) einen Transistor (3), der das Eingangssignal (SDi) empfängt und mit der Modulationszelle (CMi) verbunden ist, und einen parallelen Widerstand (6) zwischen dem Transistor (3) und Masse umfasst.

18. Schaltung nach einem der Ansprüche 10 bis 17, **dadurch gekennzeichnet, dass** sie eine verteilte Struktur aufweist, die mehrere abgeleitete Zweige (Bi), die jeweils Folgendes umfassen: wenigstens eine Modulationszelle (CMi) zum Empfangen von zwei digitalen Steuersignalen (SCji1, SCji2) umfassen, wobei jeder abgeleitete Zweig (Bi) ein Signal liefert, moduliertes Zweigausgangssignal (Ssi) genannt, und Mittel (12) zum Phasensummieren der modulierten Zweigausgangssignale (Ssi) von den verschiedenen abgeleiteten Zweigen (Bi), um ein moduliertes Ausgangssignal (Ss) zu bilden.

**Claims**

1. A method for modulating a periodic carrier signal (Se) with a digital modulation signal (SCj), implemented by a modulator circuit (1) comprising at least one modulation cell (CMi) intended to receive two digital control signals (SCji1, SCji2) capable of being equal to 0 or to 1, representing at least a part of the digital modulation signal (SCj), in which, for at least one value of the digital modulation signal (SCj), two digital control signals (SCji1, SCji2) of equal value are applied to at least one given modulation cell (CMi) and, for at least one other value of the digital modulation signal (SCj), two digital control signals (SCji1, SCji2) of complementary values are applied to this (these) modulation cell(s) (CMi).

2. The method as claimed in claim 1, **characterized in that** at least one modulation cell (CMi) receiving two digital control signals (SCji1, SCji2) of equal value for at least one value of the digital modulation signal (SCj) is designed to deliver a signal, referred to as a modulated elementary signal (Ssi), which is zero for this value of the digital modulation signal (SCj).

3. The method as claimed in one of claims 1 or 2, **characterized in that** at least one modulation cell (CMi) is a phase-shift keying modulation cell.

4. The method as claimed in one of claims 1 to 3, **characterized in that** at least one modulation cell (CMi) is designed to deliver a modulated elementary signal (Ssi) with two phase states in opposition and a single amplitude state when it receives complementary digital control signals (SCji1, SCji2), and to deliver a modulated elementary signal (Ssi) which is zero when it receives digital control signals (SCji1, SCji2) of equal value.

5. The method as claimed in claim 4, **characterized in that**, when the two digital control signals (SCji1, SCji2) are of equal value, they are both equal to 0.

6. The method as claimed in one of claims 1 to 5, **characterized in that** the modulator circuit (1) comprises at least two modulation cells (CMi), and wherein, for at least one value of the digital modulation signal (SCj), two digital control signals (SCji1, SCji2) of equal value are applied to at least one modulation cell (CMi) and two digital control signals (SCji1, SCji2) of complementary values are applied to at least one other modulation cell (CMi).

7. The method as claimed in one of claims 1 to 6, **characterized in that**, an input signal (SDi) coming from the carrier signal (Se) is delivered to each modulation cell (CMi) via impedance matching means (2), which are designed so that the modulation cell (CMi) is at least substantially impedance-matched both when the digital control signals (SCji1, SCji2) that it receives are complementary and when they are equal.

8. The method as claimed in claim 7, **characterized in that** the impedance matching means (2) comprise, for each modulation cell (CMi), a transistor (3), which receives the input signal (SDi) and is connected to the modulation cell (CMi), and a parallel resistor (6) between the transistor (3) and ground.

9. The method as claimed in one of claims 1 to 8, **characterized in that** a modulator circuit (1) is used with a distributed structure comprising a plurality of derived branches (Bi), each comprising at least one modulation cell (CMi) intended to receive two digital control signals (SCji1, SCji2), each derived branch (Bi) delivering a signal referred to as a modulated branch-output signal (SCi), and **characterized in that** the modulated branch-output signals (Ssi) coming from the various derived branches (Bi) are added in phase in order to form a modulated output signal (Ss).

10. A modulator circuit capable of modulating a periodic carrier signal (Se) with a digital modulation signal (SCj), comprising at least one modulation cell (CMi) intended to receive two digital control signals (SCji1, SCji2) capable of being equal to 0 or to 1, representing at least a part of the digital modulation signal (SCj), this circuit being designed so that, for at least one value of the digital modulation signal (SCj), at least one given modulation cell (CMi) receives two digital control signals (SCji1, SCji2) of equal value, and so that, for at least one other value of the digital modulation signal (SCj), this (these) modulation cell(s) (CMi) receives two digital control signals (SCji1, SCji2) of complementary values.

11. The circuit as claimed in claim 10, **characterized in that** at least one modulation cell (CMi) receiving two digital control signals (SCji1, SCji2) of equal value for at least one value of the digital modulation signal (SCj) is designed to deliver a signal, referred to as a modulated elementary signal (Ssi), which is zero for this value of the digital modulation signal (SCj).

**12.** The circuit as claimed in one of claims 10 or 11, **characterized in that** at least one modulation cell (CMi) is a phase-shift keying modulation cell.

**13.** The circuit as claimed in one of claims 10 to 12, **characterized in that** at least one modulation cell (CMi) is designed to deliver a modulated elementary signal (Ssi) with two phase states in opposition and a single amplitude state when it receives complementary digital control signals (SCji1, SCji2), and to deliver a modulated elementary signal (Ssi) which is zero when it receives digital control signals (SCji1, SCji2) of equal value.

**14.** The circuit as claimed in claim 13, **characterized in that**, when the two digital control signals (SCji1, SCji2) are of equal value, they are both equal to 0.

**15.** The circuit as claimed in one of claims 10 to 14, **characterized in that** it comprises at least two modulation cells (CMi), and that it is designed so that, for at least one value of the digital modulation signal (SCj), at least one modulation cell (CMi) receives two digital control signals (SCji1, SCji2) of equal value and at least one other modulation cell (CMi) receives two digital control signals (SCji1, SCji2) of complementary values.

**16.** The circuit as claimed in one of claims 10 to 15, **characterized in that** it comprises, upstream of each modulation cell (CMi), impedance matching means (2) which supply the modulation cell (CMi) with an input signal (SDi) coming from the carrier signal (Se) and which are designed so that the modulation cell (CMi) is at least substantially impedance-matched both when the digital control signals (SCji1, SCji2) that it receives are complementary and when they are equal.

**17.** The circuit as claimed in claim 16, **characterized in that** the impedance matching means (2) comprise, for each modulation cell (CMi), a transistor (3), which receives the input signal (SDi) and is connected to the modulation cell (CMi), and a parallel resistor (6) between the transistor and ground.

**18.** The circuit as claimed in one of claims 10 to 17, **characterized in that** it has a distributed structure comprising a plurality of derived branches (Bi), each comprising at least one modulation cell (CMi) intended to receive two digital control signals (SCji1, SCji2), each derived branch (Bi) delivering a signal referred to as a modulated branch-output signal (Ssi), and means (12) for adding in phase the modulated branch-output signals (Ssi) coming from the various derived branches (Bi) in order to form a modulated output signal (Ss).

FIG.1

EP 1 316 142 B1

FIG.2

EP 1 316 142 B1

FIG. 3

FIG. 4

FIG. 5